# EUROPEAN PATENT APPLICATION

(11) **EP 2 017 315 A1**
(43) Date of publication of application: **21.01.2009**
(21) Application number: 07742069.3
(22) Date of filing: 20.04.2007
(51) Int. Cl.: C09J 7/02

(54) **ADHESIVE TAPE**

(30) Priority: 24.04.2006 JP 2006119084; 29.08.2006 JP 2006232554
(71) Applicant: Hitachi Chemical Company, Ltd., Tokyo 163-0449 (JP)
(72) Inventor: YANAGAWA, Toshiyuki, Chikusei-shi, Ibaraki 308-8524 (JP)
(74) Representative: Jönsson, Hans-Peter
(86) International application number: PCT/JP2007/058634
(87) International publication number: WO 2007/125830

(57) **Abstract**

An adhesive tape 1 comprises a tape-like base 10 and a tape-like adhesive material 20 provided on the main surface 11 of the base 10. A linear slit 12 for dividing and peeling the base 10 is provided along the longitudinal direction of the base 10.

## Description

### Technical Field

The present invention relates to an adhesive tape comprising a base and an adhesive material.

### Background Art

Adhesive tapes are conventionally used for bonding and fixing circuit boards to electronic components such as liquid crystal panels, PDPs (plasma display panels), EL (Electroluminescent displays), paired-chip packages and the like. Circuit boards are also adhered and fixed among them by way of adhesive tapes that electrically connect electrodes of both circuit boards. For instance, Patent documents 1 and 2 disclose adhesive tapes in which an adhesive material for electric connection is coated onto a base.
[Patent document 1] Japanese Patent Application Laid-open No. 2001-284005
[Patent document 2] Japanese Patent Application Laid-open No. 2004-200605

### Disclosure of the Invention

### Problems to be Solved by the Invention

The use of adhesive tapes is wide-ranging, from IC driving to power supply applications, and it is not uncommon to find two or more kinds of adhesive tape, each for a respective purpose, in a same article. Also, the positions at which these various adhesive tapes are used may stand close to each other, as a result of the current trend towards greater panel sizes, narrower frames, and space saving features.

Ordinarily, the various adhesive tapes are selectively used in accordance with their respective applications, as described above. In recent years, however, there have been ongoing attempts at using one shared adhesive tape for multiple purposes. In particular, when the positions at which the above plural adhesive tapes are used stand are close to one another, there have been attempts at using a same adhesive tape for bonding members to be bonded, of dissimilar purposes, on a right side and a left side relative to a width direction. Doing so is advantageous in terms of, for instance, reducing the amount, and hence the cost, of adhesive tape used, and in terms of easing the environmental burden involved, by cutting down on industrial waste.

Such adhesive tapes are, for instance, wound on a reel that is fitted in a bonding apparatus, the leading end of the adhesive tape being pulled out and attached to a winding reel. The adhesive tape paid out from the adhesive material reel is pressure-bonded, from the side of a base, to a pressure-bonding circuit board or the like, by way of a heating and pressing head, whereupon the residual base is wound on a winding reel.

The shorter the time elapsed from peeling of the base off the adhesive material until bonding to the member to be bonded, the better it is in consideration of, for instance, changes in the condition of the surface of the adhesive material. When the time elapsed since base peeling exceeds a given time, the adhesive portion of the adhesive material becomes exposed, for instance, to air and moisture in air, which, depending on the type of the adhesive material, may give rise to connection defects on account of impaired adherence. Also, small amounts of dust or dirt may adhere to the adhesive material, depending on the environment in which the adhesive material is used, for instance in terms of room cleanliness. Such dust and dirt behave as foreign matter during bonding, and may give rise to connection defects similar to those described above.

Therefore, when the time elapsed between the bonding step of a first member to be bonded and the bonding step of a second member to be bonded is prolonged during bonding, using a same adhesive tape, of members to be bonded having dissimilar purposes, on a right side and a left side relative to a width direction, as described above, the portion of the adhesive material with which the second member is to be bonded becomes exposed to air and so forth during the lapse of time between bonding of the first member to be bonded and bonding of the second member to be bonded. Therefore, the adherence of the adhesive material may be impaired through adhesion of air moisture and/or dust onto the exposed portion, which in turn may give rise to problems during bonding of the second member to be bonded. The bonding step of the members to be bonded can conceivably be modified in order to avoid the above problem, but this may be unfeasible owing to production process constraints.

It is thus an object of the present invention to provide an adhesive tape that preserves adhesive material adherence regardless of the way in which bonding is carried out.

### Means for Solving the Problems

The adhesive tape of the present invention is an adhesive tape comprising a tape-like base and an adhesive material provided on a main surface of the base, wherein the base is provided with a slit that allows dividing and peeling the base.

The adhesive tape of the present invention comprises a slit provided in a base, and hence the base can be easily divided and peeled along the slit. When using such an adhesive tape to bond and fix to one substrate, for instance, two members to be bonded, of dissimilar purposes, at positions close to each other, the rear face of the adhesive material of the adhesive tape is first fixed to the substrate. In that situation, one side region alone of the base is peeled off along the slit provided in the base, to expose the adhesive material corresponding to that region, whereupon the first member to be bonded is fixed to the exposed portion. The remaining base on the other side is then peeled off, to expose the adhesive material corresponding to that region, whereupon the second member to be bonded is fixed to the exposed portion. Herein, the region of the adhesive material used for bonding the second member to be bonded, in a subsequent step, remains protected by the base after bonding of the first member to be bonded, and hence the region in question is not exposed to air and the like. Peeling thus the region of the base corresponding to the bonding region of the adhesive material immediately before use allows preventing adhesion of air moisture and/or dust onto the adhesive material, thereby preserving the adherence of the latter.

In the adhesive tape of the present invention, preferably, the slit is provided along the longitudinal direction of the base.

Sufficient base strength can then be secured in the pulling direction (longitudinal direction) of the adhesive tape, whereby the adhesive material can be effectively paid out of a reel or the like.

In the adhesive tape of the present invention, preferably, the slit is linear and is provided 0.3 mm or more inwards from at least one end of the base.

The regions of the base on both sides of the slit have thus some width. This way, the base exhibits appropriate strength in the longitudinal direction of the adhesive tape, after peeling along the boundary formed by the slit. This allows preventing, as a result, the peeled base from breaking at an unexpected point in the width direction of the adhesive tape. The peeled base, moreover, has a predetermined width such that the region of the adhesive material exposed after peeling is adequately wide, thanks to which the substrate and the members to be bonded can be bonded satisfactorily.

In the adhesive tape of the present invention, preferably, the adhesive material has conductive particles dispersed therein. In particular, the adhesive material becomes an anisotropic conductive adhesive when conductive particles of specific volume are dispersed in the adhesive material. The substrate and the members to be bonded can be electrically connected as a result.

### Effects of the Invention

In the present invention, providing a slit in a base allows exposing a region corresponding to an adhesive material by peeling off only a partial region of the base. The adherence of the adhesive material can therefore be preserved regardless of the way in which bonding is carried out, using one same adhesive tape. This allows widening the scope for creation of new electronic device articles and allows overcoming problems during electronic device manufacture, while enhancing productivity.

### Brief Description of the Drawings

Fig. 1 is a perspective-view diagram of an adhesive tape according to an embodiment;
Fig. 2 is a cross-sectional diagram of the adhesive tape illustrated in Fig. 1 along line II-II;
Fig. 3 is a perspective-view diagram illustrating the adhesive tape illustrated in Fig. 1, with a base partially peeled off;
Fig. 4 is a perspective-view diagram illustrating the adhesive tape illustrated in Fig. 1, wound on a reel;
Fig. 5 is a schematic side-view diagram of a bonding apparatus onto which the adhesive tape illustrated in Fig. 1 is mounted;
Fig. 6 is a perspective-view diagram illustrating an example of a method of using the adhesive tape illustrated in Fig. 1;
Fig. 7 is a cross-sectional diagram illustrating an example of a method of using the adhesive tape illustrated in Fig. 1;
Fig. 8 is a perspective-view diagram illustrating an example of a method of using the adhesive tape illustrated in Fig. 1;
Fig. 9 is a cross-sectional diagram illustrating an example of a method of using the adhesive tape illustrated in Fig. 1;
Fig. 10 is a perspective-view diagram illustrating an example of a method of using the adhesive tape illustrated in Fig. 1; and
Fig. 11 is a perspective-view diagram illustrating an example of a method of using the adhesive tape illustrated in Fig. 1.

### Explanation of Reference Numerals

1 adhesive tape
10 base
11 main surface
12 slit
20 adhesive material

### Best Mode for Carrying Out the Invention

Embodiments of the present invention are explained next with reference to accompanying drawings. In the explanation of the drawings, identical elements are denoted with identical reference numerals, and recurrent explanations thereof are omitted.

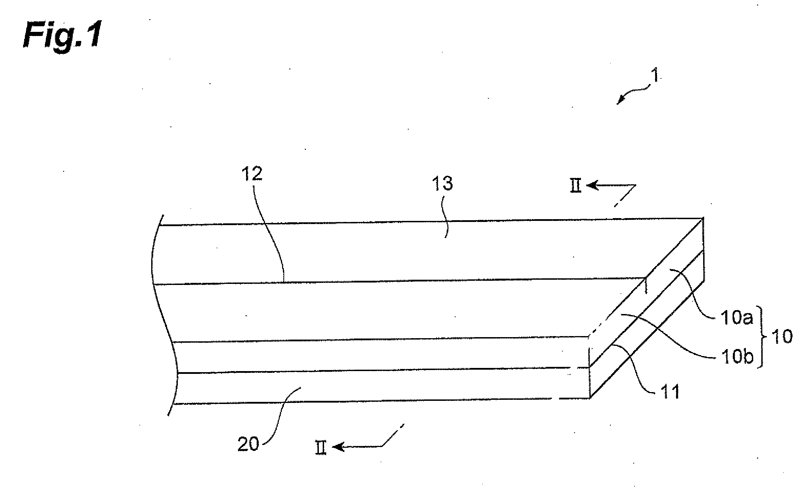

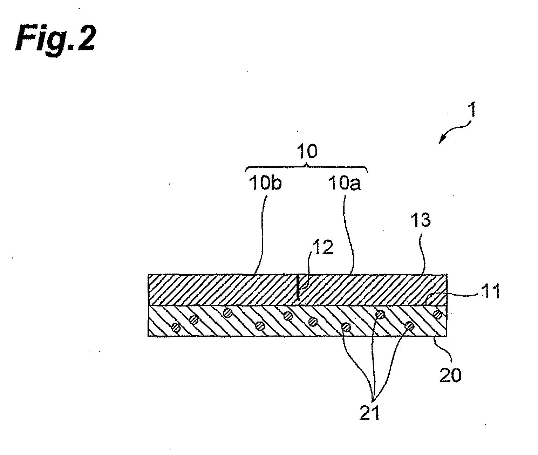

An embodiment of an adhesive tape 1 according to the present invention is explained first with reference to Figs. 1 to 4. Fig. 1 is a perspective-view diagram of the adhesive tape 1 according to the present embodiment. Fig. 2 is a cross-sectional diagram of the adhesive tape 1 illustrated in Fig. 1 along line II-II.

The adhesive tape 1 in the figures comprises a tape-like base 10 and an adhesive material 20 formed on one main surface 11 of the base 10. The adhesive tape 1 has a length of, for instance, about 50 to 200 m, and a width of, for instance, about 0.5 to 10 mm.

The base 10 comprises, for instance, OPP (oriented polypropylene), polytetrafluoroethylene, PET (polyethylene terephthalate) or the like. The surface of these materials may be subjected to a silicone treatment. Using such materials allows increasing the strength of the base 10 and enhancing the releasability of the base 10 from the adhesive material 20. The material of the base 10, however, is not limited to the foregoing materials.

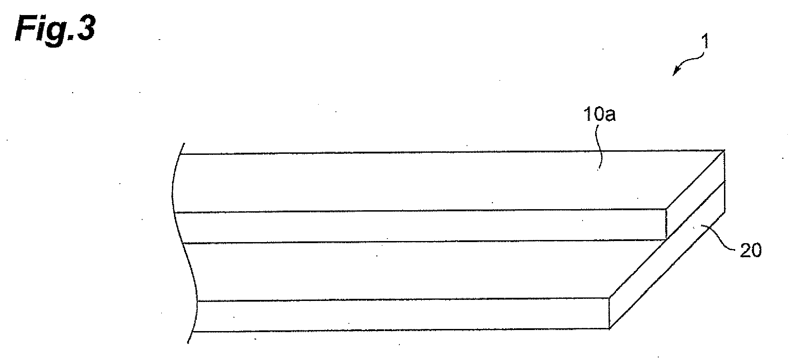

A linear slit 12 for dividing and peeling the base 10 is provided in the base 10. The slit 12 is provided continuously along the longitudinal direction of the base 10, from the leading end to the trailing end of the base 10. The slit 12 extends, in the middle of the width direction of the base 10, from the front surface 13 of the base 10 (surface of the opposite side of the adhesive material 20) to halfway between the front surface 13 and the adhesive material 20. The base 10 is divided into a divided base 10a and a divided base 10b, with the slit 12 as the boundary therebetween. As illustrated in Fig. 3, a region of the adhesive material 20 corresponding to the divided base 10a or the divided base 10b can be exposed by easily peeling either the divided base 10a or the divided base 10b alone, with the slit 12 as the peeling starting point. Needless to say, the entire surface of the adhesive material 20 can also be exposed by peeling the divided bases 10a, 10b simultaneously.

The slit 12 is preferably provided 0.3 mm or more inwards from at least one end of the base 10. This way, the divided base 10a or the divided base 10b exhibits appropriate strength, in the longitudinal direction of the adhesive tape 1, after peeling along the boundary formed by the slit 12. This allows preventing the peeled divided base 10a or divided base 10b from breaking at an unexpected point in the width direction of the adhesive tape 1, and allows securing a sufficient adhesive surface area of the adhesive material 20, exposed after peeling, since the width of the divided base 10a or the divided base 10b after peeling is 0.3 mm or more. Moreover, the unpeeled base 10 is prevented thereby from forming a step on the adhesive material 20 that could preclude sufficient pressure from bearing on the adhesive material 20 during heating and pressing of the adhesive material 20 by way of a below-described heating and pressing head 43. Defective contact is thus prevented as a result.

The adhesive material 20 comprises, for instance; a thermoplastic resin, a thermosetting resin or a mixture of the foregoing. Examples of thermoplastic resins include, for instance, styrene resins and polyester resins. Examples of thermosetting resins include, for instance, epoxy resins and silicone resins. The adhesive material 20 may comprise a thermal radical-curable resin having high reactivity and capable of low-temperature bonding in a short time. Examples of adhesive materials comprising a thermal radical-curable resin include, for instance, acrylic resins.

Conductive particles 21 may be dispersed in the adhesive material 20, with the dispersion amount ranging from 0.1 to 30 vol% relative to the total adhesive component, in which case the adhesive material 20 functions as an anisotropic conductive adhesive material through which current flows only in a perpendicular direction. Examples of the conductive particles 21 that can be used include, for instance, metal particles of gold (Au), silver (Ag), platinum (Pt), nickel (Ni), copper (Cu), tungsten (W), antimony (Sb), tin (Sn), solder or the like; particles obtained by forming a conductive layer comprising a metal such as gold (Au), silver (Ag), nickel (Ni), copper (Cu) or solder on the surface of a spherical core comprising carbon, graphite or a polymer such as polystyrene; or particles obtained by forming a surface layer of gold (Au), silver (Ag), nickel (Ni), solder or the like on the surface of conductive particles.

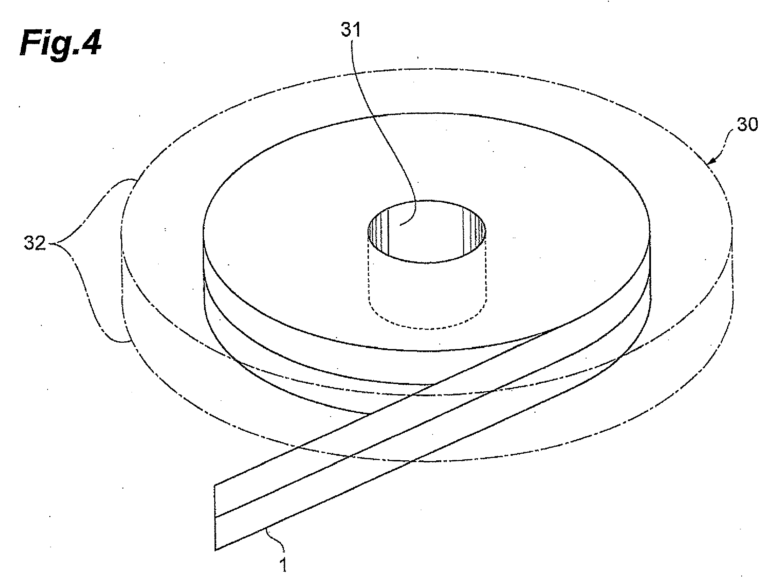

As illustrated in Fig. 4, the adhesive tape 1 is wound around a reel 30 that comprises side plates 32 mounted on both ends of a winding core 31. The handleability of the adhesive tape 1 can be enhanced, in terms, for instance, of facilitating fitting on a below-described bonding apparatus 40, by winding the adhesive tape 1 on the reel 30. The slit 12 of the base 10 is provided along the longitudinal direction of the base 10, and hence sufficient base strength can be secured in the pulling direction (longitudinal direction) of the adhesive tape 1. The adhesive tape 1 can thereby be easily paid out from the reel 30.

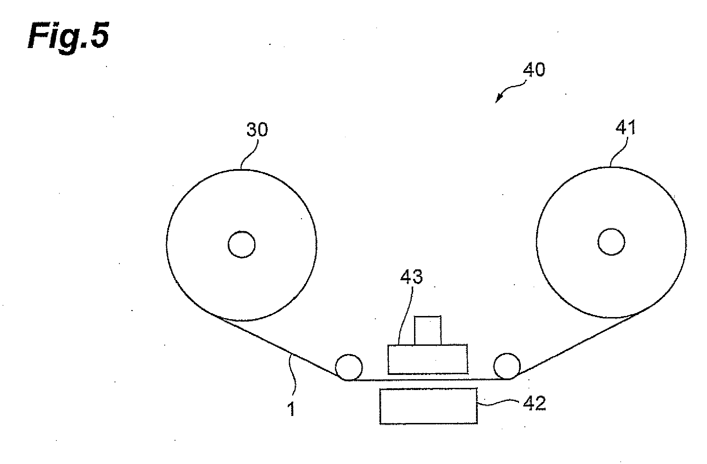

A method of using the adhesive tape 1 is explained next with reference to Figs. 5 to 11. Specifically, an explanation follows next on a method for realizing electric connection in which a wiring circuit 60 and a wiring circuit 70 are bonded to a circuit board 50 using the adhesive tape 1.

The reel 30, around which the adhesive tape 1 is wound, is mounted on a bonding apparatus 40, as illustrated in Fig. 5. In addition to the reel 30, the bonding apparatus 40 comprises a winding reel 41, a support stand 42 disposed between the reel 30 and the winding reel 41, and a heating and pressing head 43 provided above the support stand 42. The leading end of the adhesive tape 1 is wound on the winding reel 41 in such a manner that the adhesive tape 1 passes between the support stand 42 and the heating and pressing head 43.

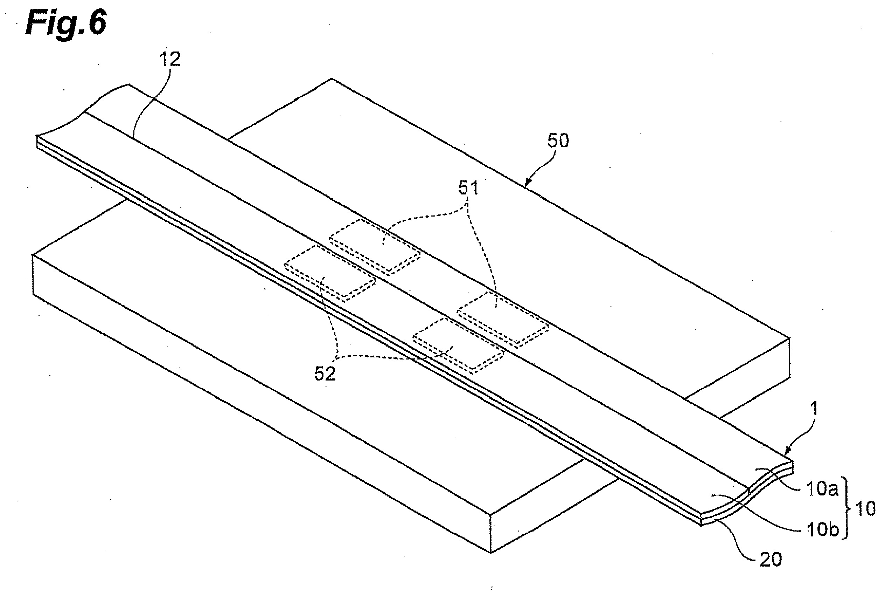

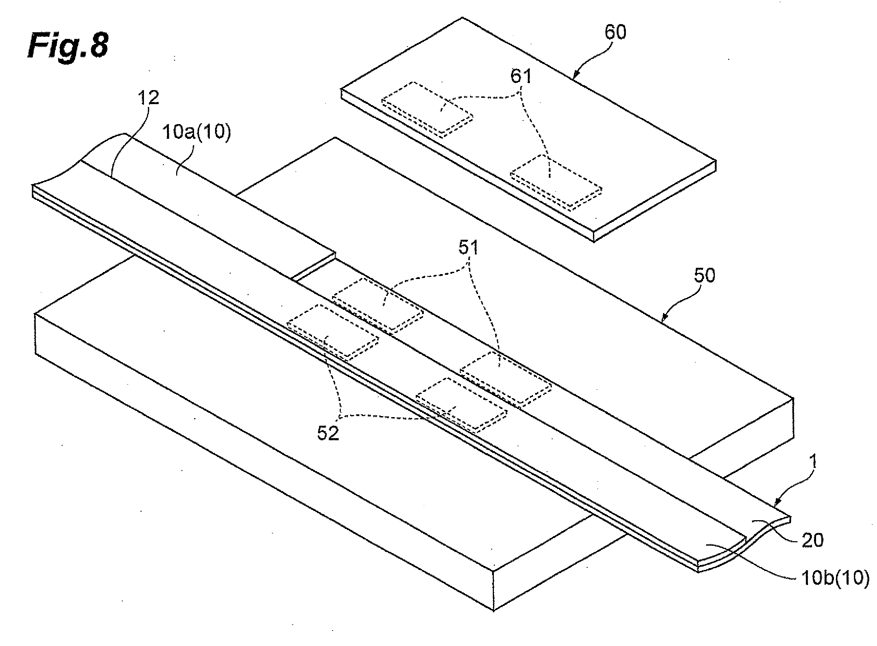

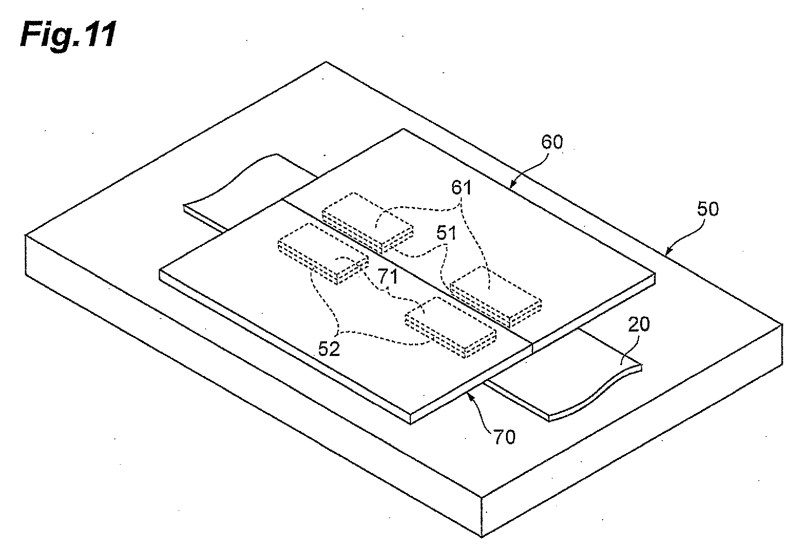

Firstly, the circuit board 50 is disposed above the support stand 42. As illustrated in Fig. 6, a plurality of electrodes 51 and electrodes 52 are provided parallelly on the top face of the circuit board 50. A plurality of electrodes 61, to be electrically connected to the electrodes 51, is provided on the underside of the wiring circuit 60 (Fig. 8). A plurality of electrodes 71, to be electrically connected to the electrodes 52, is provided on the underside of the wiring circuit 70 (Fig. 11). The rear face of the adhesive material 20 of the adhesive tape 1 is affixed to the top face of the circuit board 50 in such a manner that the electrodes 51, 52 of the circuit board 50 are respectively covered by the divided bases 10a, 10b of the adhesive tape 1.

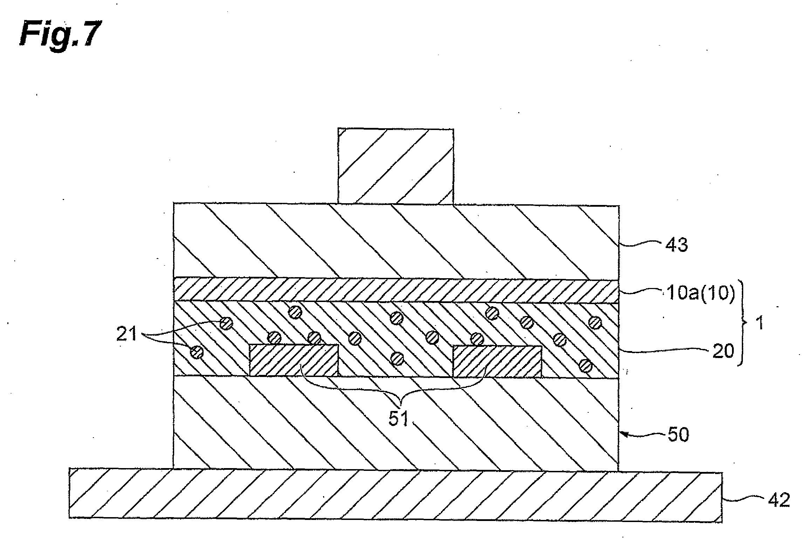

The heating and pressing head 43 descends then onto the circuit board 50, and as illustrated in Fig. 7, heats and presses the adhesive tape 1 against the circuit board 50. As a result, the adhesive material 20 is pressure-bonded to the circuit board 50 to cover the electrodes 51, 52. Thereafter, the heating and pressing head 43 withdraws upwards. In that state, the pressure-bonded portion of the divided base 10a is peeled off the adhesive material 20 along the slit 12, to expose thereby the adhesive material 20 at that portion, as illustrated in Fig. 8. The region of the divided base 10b adjacent to the peeled portion remains unpeeled, the adhesive material 20 of the region in question remaining still protected by the divided base 10b.

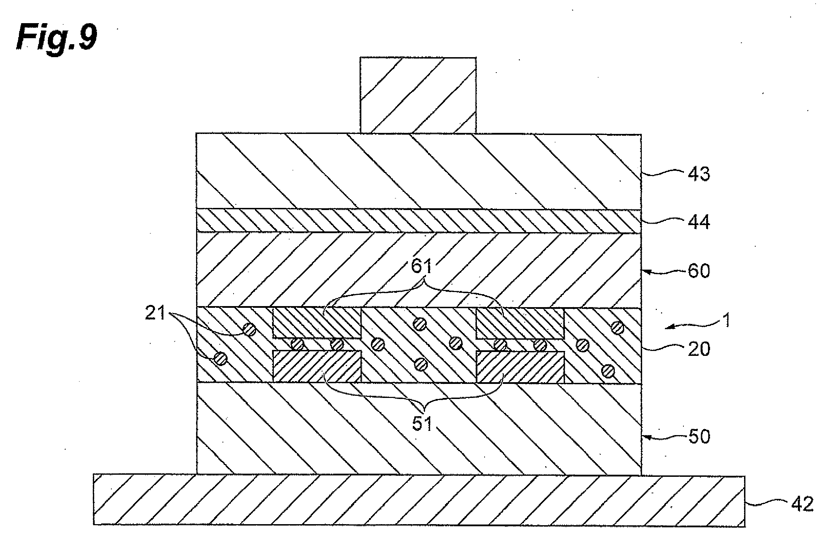

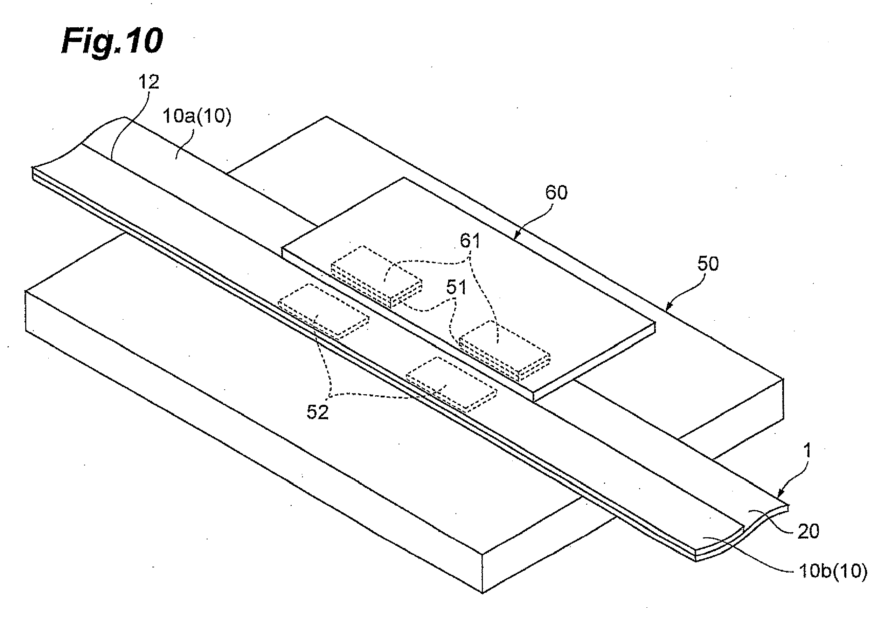

Next, the wiring circuit 60 is bonded and fixed to the circuit board 50 as illustrated in Fig. 8. Specifically, the wiring circuit 60 is disposed over the circuit board 50 in such a manner that the electrodes 51 of the circuit board 50 match the electrodes 61 of the wiring circuit 60. The heating and pressing head 43 descends then onto the wiring circuit 60 and heats and presses the wiring circuit 60 via a polytetrafluoroethylene material 44, as a cushion material, as illustrated in Fig. 9. The circuit board 50 and the wiring circuit 60 become thus connected via the adhesive material 20, as illustrated in Fig. 10, such that the electrodes 51 of the circuit board 50 are electrically connected to the corresponding electrodes 61 in the wiring circuit 60.

The divided base 10b is peeled off next along the slit 12, exposing thereby the adhesive material 20 at the corresponding region. Thereafter, the circuit board 50 and the wiring circuit 70 are bonded and fixed in accordance with the same method as above. As a result, the wiring circuit 60 and the wiring circuit 70, adjacent to each other, are mounted on the circuit board 50 via the adhesive material 20, as illustrated in Fig. 11. The peeled base 10 is wound on the winding reel 41.

When the adhesive tape 1 is used this way, the region of the adhesive material 20 at which the wiring circuit 70 is to be bonded remains protected by the divided base 10b after bonding of the wiring circuit 60 to the circuit board 50, so that the region in question is not exposed to air and the like. Dust and moisture in air are prevented thereby from adhering to the adhesive material 20, which allows preserving the adherence (bonding strength, fixability and so forth) of the adhesive material 20.

Splitting the base 10 is unnecessary when bonding and fixing only one wiring circuit to the circuit board 50. In this case, the base 10 may be peeled across the entire width thereof, without splitting, immediately before bonding of the wiring circuit to the circuit board 50.

The present invention has been explained on the basis of embodiments thereof, but the invention is in no way meant to be limited to or by these embodiments. Various modifications of the above-described embodiments are possible without departing from the spirit and scope of the invention.

In the above embodiment, the slit 12 is provided continuously along the longitudinal direction of the base 10, from the leading to the trailing end thereof The slit 12, however, may be provided intermittently at given intervals. In the above embodiment, also, the slit 12 extends from the front surface 13 of the base 10 to halfway between the front surface 13 and the adhesive material 20, but it may also be provided so as to extend from the front surface 13 of the base 10 to the main surface 11. In the above embodiment, the adhesive material 20 is an anisotropic conductive adhesive material, but the type of adhesive material is not limited. For instance, the adhesive material may be an insulating adhesive material having dispersed therein insulating spacer particles.

## Claims

1. An adhesive tape comprising a tape-like base and an adhesive material provided on a main surface of said base,
wherein said base is provided with a slit that allows dividing and peeling said base.

2. The adhesive tape according to claim 1, wherein said slit is provided along the longitudinal direction of said base.

3. The adhesive tape according to claim 2, wherein said slit is linear and is provided 0.3 mm or more inwards from at least one end of said base.

4. The adhesive tape according to any one of claims 1 to 3, wherein said adhesive material has conductive particles dispersed therein.
